Europäisches Patentamt

European Patent Office

Office européen des brevets

(11) Publication number: **0 259 179**
**A2**

# (12) EUROPEAN PATENT APPLICATION

(21) Application number: **87307830.7**

(22) Date of filing: **04.09.87**

(51) Int. Cl.⁴: **H 02 H 9/04**

(30) Priority: **05.09.86 GB 8621430**

(43) Date of publication of application:
**09.03.88 Bulletin 88/10**

(84) Designated Contracting States:
**AT BE CH DE ES FR GB IT LI NL SE**

(71) Applicant: **RAYCHEM LIMITED**
**Rolls House 7, Rolls Buildings Fetter Lane**
**London, EC4 1NL (GB)**

(72) Inventor: **Wright, Martin Andrew**
**27 Medgebury Road**
**Swindon Wiltshire (GB)**

(74) Representative: **Dlugosz, A.C. et al**
**Raychem Limited Intellectual Property Law Department**
**Faraday Road Dorcan**
**Swindon Wiltshire (GB)**

(54) **Overvoltage protection device.**

(57) An arrangement for protecting an electrical circuit from a voltage transient comprises a threshold foldback switching element 8 that is connected, or arranged to be connected between a current-carrying line 2 of the circuit and earth (e.g. an earth pin 2' of a connector). A capacitor 5 having a capacitance of not more than 2 microfarads is connected in series with the threshold foldback switching element 8 and the current-carrying line 2, and is such that substantially the entire transient passes through the switching element and capacitor.

EP 0 259 179 A2

**Description**

Overvoltage Protection Device

This invention relates to circuit protection devices and especially to devices for protecting electrical circuits from voltage transients that are caused by an electromagnetic pulse, e.g. lightning, and also the transients that are caused by electrostatic discharge.

Electrostatic discharge and electromagnetic pulses can all induce very high currents and voltages on cables and structures such as aeroplanes and ships, which can penetrate the electrical systems and damage them, either causing hardware damage such as semiconductor burnout, or electronic upset, e.g. transmission loss or loss of stored data. As semiconductor technology advances, the energy needed to cause such damage becomes less.

Electrostatic discharges are extremely fast discharges from a capacitor such as a human body. These discharges, because they can be so local, present an extreme threat to the individual electronic component. The magnitude of the threat is illustrated by reference to IEC Technical Committee TC65, WG4 draft specification or the SAE-AE-4 proposed specification on ESD. In these documents the maximum threat is a double exponential pulse of rise time 5 nanoseconds with a 30 nanosecond fall time. The peak voltage is given as 15,000 volts with a current of 70 amps. The energy storage capacitance is given as 150 pico farads giving a maximum energy of 33 millijoules.

Induced electrical transients caused by lightning represent a threat to electrical/electronic equipment especially in aerospace vehicles. The characteristics of the induced pulses are best described in the SAE AE4L Committee Report AE4L-81-22. Test Wave Forms and Techniques for Assessing the Effects of Lightning -Induced Transients. This specification describes the idealised versions of the lightning stroke waveform and of those which occur when equipment cables are excited by the EM environment produced. The specification specified a range of transients which may be produced during normal operation. The waveforms expected on each line depends on a number of factors but the two basic types are (waveform 3) with a frequency of between 1 and 10 MHz, a rise time of 45 nanoseconds and a peak current of 24 amps. The alternative wave form (Wave Form 4A) is a decaying exponential with a rise time of 100 nanoseconds and a width of 2 microseconds with a peak voltage of 300 volts and peak current of 60 amps.

The most severe threat to electrical and electronic equipment is the nuclear electromagnetic pulse although all effects can generate large voltage or current spikes with very short rise times. The exact characteristics of the pulse are complicated although a typical pulse will exhibit a field strength of about $10^5$ $Vm^{-1}$ with an accompanying H field intensity of 130 $Am^{-1}$ (based on free space impedance of 377 ohms), a pulse width of a few microseconds and a rise time of a few nanoseconds. In general damaging amplitudes in the pulse occur within the frequency range of 10KHz to 100MHz.

It has been proposed to use certains materials, for example certain chalcogenide glasses, in the formation of devices for protecting electrical circuits, for example as described in U.S. patent No. 3,271,591 and 3,343,034 to Ovshinsky and, U.S. patent No. 3,436,601 to Dyre, the disclosures of which are incorporated herein by reference. Some of these chalcogenide glasses may be used to form "foldback" devices, by which is meant that the device will change from a high-resistance state to a low resistance state on application of a voltage above a critical value that depends on the device. Of particular interest are "threshold" foldback devices, by which is meant devices that will change from a high resistance state to a low resistance state on application of a high voltage, called the the threshold voltage, but which will remain in their low resistance state only for as long as a small "holding" current is maintained. Other glasses can be used to form "memory" devices which will change from a high resistance state to a low resistance state on application of a high voltage and which will then remain in their low resistance state, even when no voltage is applied, until an appropriate, different, voltage pulse is applied. Only threshold devices are considered here in the manufacture of circuit protection devices since it is desirable for the device to return to its normal operating state as soon as any transient has passed.

Chalcogenide glass materials have been considered for use as circuit protection devices in view of a number of desirable properties, for example they can switch from their high resistance state to their low resistance state in a very short time, e.g. in less than 1 nanosecond, and the electrical resistance of their high and low resistance states can differ by two, three or even by four or more orders of magnitude. However, these materials, and other switching materials, can suffer from a number of disadvantages. For example, we have found that even though a switching device may be formed from a threshold material, it may easily become permanently electrically conducting, with the result that the protection device must be replaced or reset before the circuit can be used.

The present invention provides an arrangement for protecting an electrical circuit from a voltage transient, which comprises a threshold foldback switching element based on a chalcogenide glass, the threshold switching element being connected, or arranged to be connected, between a current-carrying line of the circuit and earth; and a capacitor of not more than 2 microfarads capacitance connected in series with the switching element between the threshold switching element and the current-carrying line, the arrangement having no current-carrying paths connected in parallel with the capacitor or switching element so that substantially the entire transient passes through the switching element and capacitor.

The term "earth" in this context includes any structure having an appropriate shape and/or capacity so that it can absorb charge generated by the transient, and includes for example connection to chassis of equipment and the like in vehicles such as aircraft.

The switching element should be chosen so that its threshold voltage is greater than the maximum circuit voltage.

We have observed that the problems of the previous proposals are due, at least in part, to the fact that after the transient has passed, the normal direct currents that may occur in the circuit can hold the switching element in its low resistance state indefinitely, and that very low frequency alternating current power lines in the circuit may hold the element in its low resistance state for sufficient time for the material to "latch" i.e. to adopt memory characteristics and thereby cause the device to remain permanently in its low resistance state.

According to the present invention, these problems are overcome by the provision of a capacitor in series with the switching device, between the switching device and the line. The required capacitance of the capacitor will depend on a number of factors including the material from which the switching element is formed, the nature of the transient against which the protection is desired, and the intended use of the circuit. For example, in order to protect an electrical circuit against electrostatic discharge, a capacitance of at least 1 nanofarad is preferred, and especially at least 10 nanofarads. For protection against other threats, for example as described by H.R. Philipp and L.M. Levinson in J. Appl Phys. 52(2) February, 1981 pp. 1083 to 1090, the disclosure of which is incorporated herein by reference, the capacitance may need to be larger, e.g. at least 30 and preferably at least 100 nanofarads. A capacitor of this size will allow all transients having a frequency spectrum above about 1 MHz to pass to earth and so allow the device to protect the circuit from the transient. Preferably the capacitor has a capacitance of not more than 1 and especially not more than 0.5 microfarads. The use of a capacitor of less than 2 microfarads and particularly one of less than 1 microfarad has the advantage that the switching device is itself protected by the capacitor against damage by low frequency components of the transient. On the basis of observations made, it appears that certain forms of threshold switching elements may require less electrical energy to latch them in their low resistance state at low electrical frequencies (e.g. less than 100 KHz) than at higher frequencies. Thus, many devices that exhibit acceptable energies to latch at frequencies of about 10 MHz would, in fact, latch in their low resistance state when subjected to a voltage transient due to the low frequency components of the transient if no such capacitor were provided. Any such low frequency components of the transient that are not passed to earth by the switch can easily be filtered out of the electrical circuit by conventional means with no loss to the signal carried by the circuit.

The arrangement may be incorporated in an electrical circuit in any suitable position, normally being connected between a current carrying line and earth, and, of course, more than one such device may employed in the electrical circuit. The arrangement is conveniently incorporated in other electrical components for example electrical connectors, in which case the device will usually be connected between a current carrying element of the device and a terminal or other part of the device to be earthed e.g. a conductive housing or an earth line. The fact that no conductive paths are provided in parallel with the switching element means that the capacitor is completely decoupled from the current-carrying line, which has the advantage that the circuit can operate at the same frequency as that of the transient wavefront.

In many forms of arrangement according to the invention, each switching element will be connected to a separate capacitor, and in such arrangements it may be convenient to form the capacitor and the switching element as a single unit. For example, if the capacitor has a terminal that is substantially flat, the material from which the switching element is formed may be deposited on the terminal either directly or after the terminal has been suitably prepared e.g. by the provision of a deposited layer of electrode material for the switching element for instance molybdenum. After the switching material has been deposited a second electrode layer is deposited, optionally followed by one or more further layers e.g. to improve solder adhesion.

In other forms of arrangement, however, a single capacitor may be connected to a number of switching elements for example as described in our copending Patent Application entitled "Circuit Protection Arrangement" and filed on even date herewith claiming priority from British Patent Application No. 8621431 (Agent's reference RK316).

Although in most instances the element will revert to its high resistance state as soon as the transient voltage has subsided, it is possible for the element to be forced into a permanent low resistance state, for example if the voltage transient is unduly large or if a number of rapid transients are experienced. Whether or not the element will become permanently conductive depends on the amount of energy absorbed by the device from the transient. In some applications, for example in some ground installations, it may be desirable for the protection device to fail in this way, that is to say, so that the equipment is still protected against transients but will not function until the protection device is replaced. In other applications it may be desirable for the device to fail in a high resistance (open circuit) state so that the equipment will carry on functioning although unprotected from subsequent transients. Thus the arrangement may includes means, connected in series with the switching element, that will exhibit a high resistance if the switching element becomes permanently electrically conducting. Preferably such means will exhibit such a high resistance if the switching element becomes permanently conductive that the circuit between the current carrying line and earth is effectively broken, such means including a fuse or switch. In the case of d.c. circuits or circuits carrying very low frequency alternating currents, the device may be connected between the capacitor and earth although it is preferred, especially for d.c. circuits, for the device to be connected between the current carrying line and the capacitor so that the capacitor is isolated from the line in the event that the switching element fails.

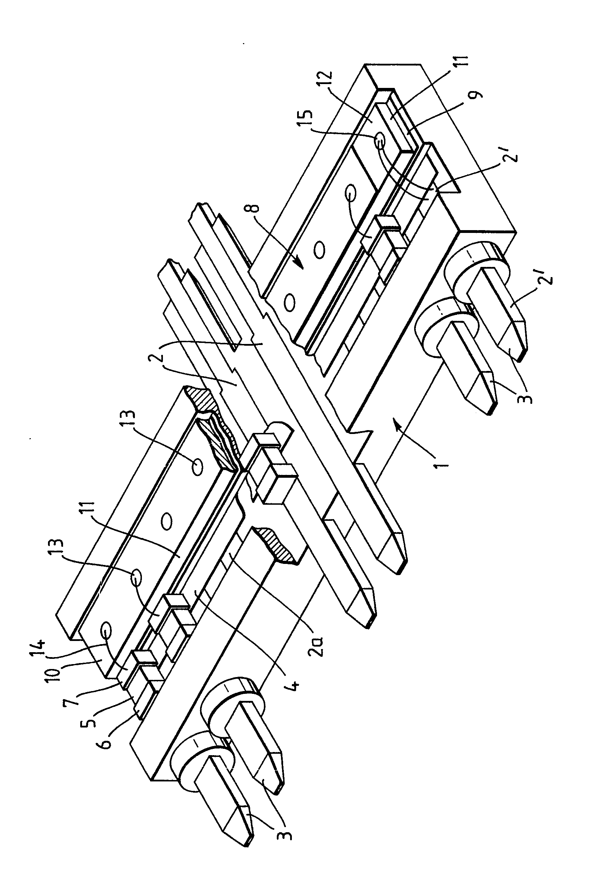

Preferably the material forming the switching element has a turn-on time of not more than 1 nanosecond, and a turn-off time of not more than 10 microseconds especially not more than 1 microsecond. Also, as explained in our copending European Patent Application No. 86302325.5 it is preferred for the material to have a critical switching field strength in the range of from $10^4$ to $10^5$ Vcm$^{-1}$ and a resistivity in its high resistance state of at least 107 ohm cm. Furthermore, preferred switching element materials will have a latching energy of at least 2000, preferably at least 4000 and especially at least 10,000 Jm$^{-1}$ (joules per metre of the element thickness) and exhibit a figure of merit of at least 10 and especially at least 20 kgm$^3$s$^{-2}$A$^{-1}$, where the figure of merit is defined as:

$$\text{figure of merit} = \frac{E_L \cdot \rho_{\text{off}}}{V_{\text{th}} \cdot \varepsilon r}$$

in which $E_L$ is the energy required to latch the material in its low resistance state (measured in joules per metre of thickness);

$\rho$off is the resistivity of the material in its high resistance state (measured in ohm metres);

$V_{\text{th}}$ is the threshold field strength of the material (measured in volts per metre); and

$\varepsilon r$ is the dielectric constant of the material.

The switching element is preferably formed from a chalcogenide glass, by which is meant a glass formed from one or more elements of group VIB of the periodic table (IUPAC 1965 revision) together with one or more elements of group IVB and/or VB and optionally IIIB for example as described in U.S. Patent No. 3,271,591 to Ovshinsky. Preferred chalcogenide glasses, which can be used to form elements having the preferred properties mentioned above are described in our copending European Application mentioned above. These glasses comprise germanium, selenium and arsenic optionally together with minor amounts of other materials. Preferably the glasses comprise:     (a) 5 to 42 atomic % germanium;
(b) 15 to 75 atomic % selenium; and
(c) 10 to 65 atomic % arsenic;
in which the proportions of (a), (b) and (c) (based on the total molar quantity of (a), (b) and (c) but excluding any optional additional materials) add up to 100%.

Preferably the composition contains not more than 35 atomic % germanium, more preferably not more than 30 atomic % germanium, and especially not more than 25 atomic % germanium. Also, the composition preferably contains at least 20 atomic % selenium and especially at least 30 atomic % selenium but preferably not more than 70 atomic % selenium and especially not more than 60 atomic % selenium. The composition preferably contains at least 20 atomic % arsenic and especially at least 25 atomic % arsenic, but especially not more than 55 atomic % arsenic. Thus the composition preferably comprises:     (a) 5 to 30 atomic % germanium;
(b) 20 to 70 atomic % selenium; and
(c) 20 to 60 atomic % arsenic,
and most preferably comprises:
(a) 5 to 25 atomic % germanium;
(b) 30 to 60 atomic % selenium; and
(c) 25 to 55 atomic % arsenic.

All the proportions of the components (a), (b) and (c) are based on the total molar quantity of (a), (b) and (c) alone and total 100%.

Several embodiments of the invention will now be described by way of example, with reference to the accompanying drawing which is a schematic, partially cut-away isometric view of part of an electrical connector that employs a device in accordance with the invention.

Referring to the accompanying drawing, a wafer 1 for insertion into a mass termination connector housing such as described in British Patent Specification No. 1,522,485 has ten metallic conductors 2 extending through it. At one end the conductors 2 are in the form of pins 3 for mating with "tuning fork" contacts of a complementary connector, and at the other end the conductors are arranged for connection to a flat cable or to a number of small primary wires. The end conductor 2' is connected to ground. The particular means used for connecting the conductors 24 to the wires or flat cable is not shown but usually comprises one or more solder devices as described in U.S. Patent Specification No. 3,852,517.

A stepped recess is formed on one side of the wafer 1 which extends transversely across the entire width of the wafer, the deepest part of the recess exposing a portion 2a of each of the conductors 2. A strip of insulating, preferably adhesive, film 4 is laid along part of the recess to obscure part of the exposed conductors 2, and a 100 nanofarad capacitor 5 is positioned against each conductor 2 so that one electrode 6 thereof is in contact with the conductor and is soldered or otherwise connected to it, while the other electrode 7 rests on the insulating film 4. In the shallower part of the recess a bank 8 of nine chalcogenide glass switches, one for each live conductor, is located on an adhesive strip 9. The switches are formed by depositing a continuous ten micrometre thick layer 10 of the chalcogenide glass onto a copper lower electrode 11 so that the glass layer extends along the electrode 11 over its entire length except for a region 12 that is positioned over the ground pin conductor 2'. Nine copper/gold spot electrodes 13 are formed on the glass layer 10 and a wire bond 14 is formed between each electrode 13 and electrode 7 of each capacitor 5. In addition, a gold contact 15 is formed on the copper lower electrode 11 which is wire bonded to the exposed portion of the ground conductor 2'.

In normal operation, all the conductors 2 are isolated from one another and from the ground conductor 2' by the high resistance chalcogenide glass layer 10. When any of the lines connected to the conductors 2 experiences a transient, the capacitor 5 will exhibit a low impedance to the transient due to its high frequency, and the switch formed by the chalcogenide glass layer 10 and electrodes 11 and 12 will allow the transient to pass to the ground conductor 2'. In the event that the conductor or conductors that experience the transient carry a direct current with a potential relative to the ground conductor that is higher than that necessary to hold the glass layer 10 in its low resistance state the presence of the capacitor 5 will prevent flow of any current, and the glass 10 will therefore immediately revert to its high resistance state. In the case where the line carries a low frequency alternating current, latching of the glass layer 10 may be prevented by the impedance of the capacitor 5, and/or by the fact that the glass will revert to its high resistance state as the instantaneous current reaches zero during change of phase in a single a.c. cycle.

**Claims**

1. An arrangement for protecting an electrical circuit from a voltage transient, which comprises a threshold foldback switching element based on a chalcogenide glass, the threshold switching element being connected, or arranged to be connected, between a current-carrying line of the circuit and earth, and a capacitor of not more than 2 microfarads capacitance connected in series with the switching element between the threshold switching element and the current-carrying line, the arrangement having no current-carrying paths connected in parallel with the capacitor or switching element so that substantially the entire transient passes through the switching element and capacitor.

2. An arrangement as claimed in claim 1, wherein the capacitor has a capacitance of at least 10 nanofarads preferably at least 100 nanofarads.

3. An arrangement as claimed in claim 1 or claim 2, wherein the capacitor has a capacitance of not more than 1 microfarad.

4. An arrangement as claimed in any one of claims 1 to 3, wherein the switching element has a turn-on time of not more than 1 nanoseconds.

5. An arrangement as claimed in any one of claims 1 to 4, wherein the switching element has a latching energy of at least 20 mJ and preferably at least 40 mJ.

6. An arrangement as claimed in any one of claims 1 to 5, wherein the switching element has a critical switching field strength from $10^4$ to $10^5$ Vcm$^{-1}$.

7. An arrangement as claimed in any one of claims 1 to 6, which includes a device, connected in series with the switching element, that will exhibit a high resistance if the switching element becomes permanently electrically conducting.

8. An arrangement as claimed in any one of claims 1 to 7, wherein the switching element comprises an amorphous composition comprising germanium, selenium and arsenic.

9. An electrical circuit which includes a current-carrying line, the circuit being protected from a voltage transient by means of an arrangement comprising a threshold foldback switching element based on a chalcogenide glass that is connected between the current-carrying line and earth, and a capacitor of not more than 2 microfarads capacitance connected in series with the switching element between the threshold switching element and the current-carrying line, the arrangement having no current-carrying paths connected in parallel with the capacitor or switching element so that substantially the entire transient passes through the switching element and capacitor.